(19) Europäisches Patentamt
European Patent Office
Office européen des brevets

(11) **EP 2 068 391 A2**

(12) **EUROPÄISCHE PATENTANMELDUNG**

(43) Veröffentlichungstag:
**10.06.2009  Patentblatt 2009/24**

(51) Int Cl.:
***H01P 3/02*** *(2006.01)*

(21) Anmeldenummer: **08018960.8**

(22) Anmeldetag: **30.10.2008**

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**
Benannte Erstreckungsstaaten:
**AL BA MK RS**

(30) Priorität: **04.12.2007  DE 102007058206
20.02.2008  DE 102008009955**

(71) Anmelder: **Rohde & Schwarz GmbH & Co. KG
81671 München (DE)**

(72) Erfinder:
• **Katzer, Michael
80337 München (DE)**
• **Reichel, Thomas
85598 Baldham (DE)**
• **Peschke, Martin
81549 München (DE)**

(74) Vertreter: **Körfer, Thomas et al
Mitscherlich & Partner
Patent- und Rechtsanwälte
Sonnenstrasse 33
80331 München (DE)**

(54) **Einrichtung mit überkreutzter Streifenleitung**

(57)   Zur Übertragung von elektrischen Signalen wird eine Einrichtung mit einem Substrat (95) und zumindest zwei Streifenleitungen (96, 97) eingesetzt. Die zumindest zwei Streifenleitungen (96, 97) sind dabei an oder in dem Substrat (95) angebracht und weisen mehrere Überkreuzungen auf. Die Überkreuzungen sind in festgelegten Abständen über die Länge der Streifenleitungen (96, 97) verteilt.

Fig. 7

EP 2 068 391 A2

**Beschreibung**

Die Erfindung betrifft eine Einrichtung zur Übertragung von elektrischen Signalen, insbesondere eine leitungsgebundene Einrichtung zur Übertragung von hochfrequenten Gegentaktsignalen.

Herkömmlich werden zur Übertragung von Hochfrequenzsignalen Koaxialleitungen eingesetzt. Durch eine Schirmung werden Störeinkopplungen stark gedämpft. Eine Koaxialleitung erfordert jedoch einen hohen Herstellungsaufwand. Zusätzlich sind einzelne Koaxialleitungen nicht zur Übermittlung von Gegentaktsignalen geeignet. Hierfür können zwar zwei getrennte Koaxialleitungen eingesetzt werden. Das Gegentaktsignal muss hierfür jedoch in zwei getrennte Gleichtaktsignale umgewandelt werden. Dies ist nachteilhaft, da der Herstellungsaufwand der Leitungen verdoppelt ist. Außerdem summieren sich durch die unterschiedliche Führung der Leitungen einkoppelnde Störungen. Zusätzliche Störungen treten durch die Umwandlung der Signale auf. Bei Übertragung von mehr als einem Signal steigt der Aufwand weiter deutlich an.

Weiterhin ist eine Führung von zwei oder mehr Innenleitern innerhalb einer gemeinsamen Schirmung denkbar. Dies erfordert jedoch einen sehr hohen Herstellungsaufwand. Weiterhin sind Steckverbindungen für diesen Leitungstyp sehr ungebräuchlich. Generell ist eine Nutzung von Koaxialleitungen nachteilhaft, da ein nahtloser Übergang von gängiger Leiterplattentechnologie, wie sie z.B. in Messgeräten eingesetzt wird auf Koaxialleitungen nicht möglich ist. Jeder Übergang ist mit einer Störung der Signalübertragung verbunden. Weiterhin sind mittels Steckverbindungen realisierte Übergänge durch einen ungünstig großen Platzbedarf gekennzeichnet und verursachen ein hohes Gewicht. Auch die Schirmung der Koaxialleitungen verursacht ein hohes Gewicht.

In dem Patent US 6,822,463 B1 wird ein aktiver Tastkopf mit einer Übertragungsleitung zur Messung differentieller Signale gezeigt. Die Übertragungsleitung ist dabei als zwei getrennte Leitungen und jeweilig zugeordnete Masseleitungen ausgeführt. Durch die getrennte Übertragung der beiden Anteile des differentiellen Signals addieren sich Einkopplungen im resultierenden differentiellen Signal. Die zugeordneten Masseleitungen, welche auch der Schirmung dienen, erhöhen darüber hinaus das Gewicht. Der Anschluss der Leitungen an den Tastkopf verursacht weitere Störungen, da ein nahtloser Übergang nicht gewährleistet ist.

Der Erfindung liegt somit die Aufgabe zu Grunde, eine Vorrichtung zur Übertragung von Signalen zu schaffen, welche ein geringes Gewicht und einen geringen Raumbedarf verursacht. Weiterhin soll die Vorrichtung Einkopplungen und Störungen vermeiden und eine große Flexibilität ihres Einsatzes ermöglichen.

Die Aufgabe wird erfindungsgemäß für die Einrichtung durch die Merkmale des unabhängigen Anspruchs 1 gelöst. Vorteilhafte Weiterbildungen sind Gegenstand der hierauf rückbezogenen Unteransprüche.

Zur Übertragung von elektrischen Signalen wird eine Einrichtung mit einem Substrat und zumindest zwei Streifenleitungen eingesetzt. Die zumindest zwei Streifenleitungen sind dabei an oder in dem Substrat angebracht und weisen mehrere Überkreuzungen auf. Die Überkreuzungen sind in festgelegten Abständen über die Länge der Streifenleitungen verteilt. So können durch externe Magnetfelder und elektrische Felder verursachte Einkopplungen und Störungen ausgeglichen werden.

Die zumindest zwei Streifenleitungen sind bevorzugt zumindest abschnittsweise auf unterschiedlichen Seiten des Substrats oder unterschiedlichen Lagen eines Mehrlagensubstrats angebracht. So können die Überkreuzungen der Streifenleitungen mit geringerem Aufwand gefertigt werden. Die durch die Überkreuzungen verursachten Störungen der Signalübertragung werden so minimiert.

Vorteilhafterweise sind die Überkreuzungen der Streifenleitungen mittels Durchkontaktierungen durch das Substrat ausgeführt. So ist eine Überkreuzung der Streifenleitungen fertigungstechnisch einfach zu handhaben.

Bevorzugt sind die Überkreuzungen ohne Durchkontaktierungen durch das Substrat ausgeführt. So werden die Störungen der Signalübertragung, welche durch die Durchkontaktierungen verursacht werden, vermieden. Ein sehr gutes Hochfrequenzverhalten lässt sich so erreichen.

Das Substrat ist bevorzugt eine dielektrische Leiterplatte. So kann die sehr verbreitete Leiterplattentechnologie zum Aufbau der erfindungsgemäßen Einrichtung genutzt werden.

Vorteilhafterweise ist das Substrat flexibel. Das Substrat ist bevorzugt ein Kunststofffilm. Dies ermöglicht sehr geringe Baugrößen und eine einfache Herstellung. Weiterhin ist die so entstehende Einrichtung flexibel, was die Einsatzmöglichkeiten stark ausweitet.

Das Substrat kann verdrillt sein. Durch Verdrillung des Substrats können Überkreuzungen der Streifenleitungen mit nur sehr geringem fertigungstechnischem Aufwand realisiert werden.

Das Substrat ist bevorzugt von einer flexiblen Ummantelung, insbesondere einer Umspritzung umgeben. So wird ein Eindringen von Gegenständen in das das Substrat umgebende elektromagnetische Feld vermieden. Damit werden Störungen der Signalübertragung reduziert und das Hochfrequenzverhalten verbessert. Weiterhin bietet die Umspritzung mechanischen Schutz für das Substrat und die Streifenleitungen.

Das Substrat ist bevorzugt in einem rohrförmigen Mantelkörper eingespritzt. So ist ein weiter verbesserter mechanischer Schutz des Substrats gewährleistet. Umwelteinflüsse können so sehr sicher ausgeschlossen werden.

Vorteilhafterweise weist die Umspritzung zumindest einen Durchmesser auf, welcher dem Doppelten des größten Abstands der zumindest zwei Streifenleitungen entspricht. So wird eine ausreichende Abschirmung gegen die Übertragung störende externe Gegenstände und gegen mechanische Belastung gewährleistet.

Die zumindest zwei Streifenleitungen sind bevorzugt zur Übermittlung von Gegentakt-Signalen ausgelegt. So kann eine Vielzahl von Signalen mittels der Einrichtung übertragen werden.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:

Fig. 1      eine beispielhafte Gleichtakt-Signal-Übertragung über zwei Leitungen mit Massefläche;

Fig. 2      eine beispielhafte Gegentakt-Signal-Übertragung über zwei Leitungen mit Massefläche;

Fig. 3      ein erstes beispielhaftes Substrat mit zwei Streifenleitungen;

Fig. 4      verschiedene beispielhafte Möglichkeiten der Schirmung von Streifenleitungen;

Fig. 5      eine beispielhafte Gegentakt-Signal-Übertragung über zwei gekreuzte Leitungen mit Massefläche;

Fig. 6      ein erstes Ausführungsbeispiel der erfindungsgemäßen Einrichtung;

Fig. 7      ein zweites Ausführungsbeispiel der erfindungsgemäßen Einrichtung;

Fig. 8      ein Ersatzschaltbild eines Ausführungsbeispiels der erfindungsgemäßen Einrichtung;

Fig. 9      ein drittes Ausführungsbeispiel der erfindungsgemäßen Einrichtung;

Fig. 10     ein zweites beispielhaftes Substrat mit zwei Streifenleitern;

Fig. 11     ein viertes Ausführungsbeispiel der erfindungsgemäßen Einrichtung;

Fig. 12     ein fünftes Ausführungsbeispiel der erfindungsgemäßen Einrichtung,

Fig. 13     ein sechstes Ausführungsbeispiel der erfindungsgemäßen Einrichtung, und

Fig. 14     ein siebtes Ausführungsbeispiel der erfindungsgemäßen Einrichtung.

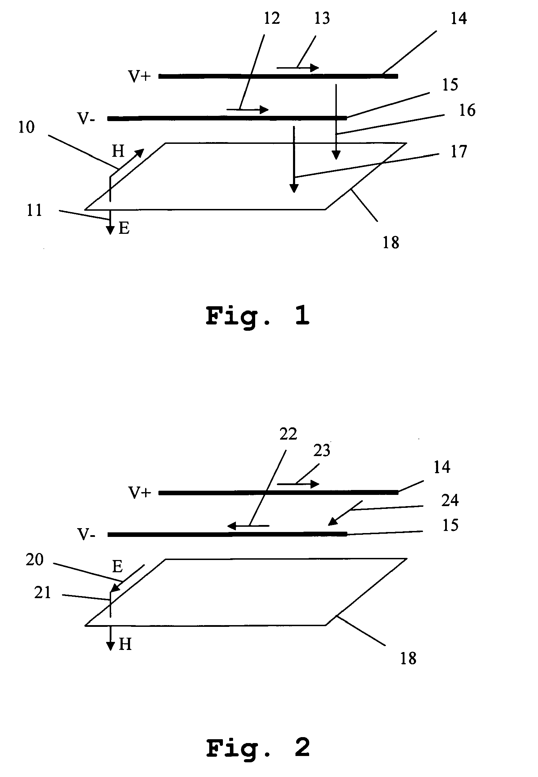

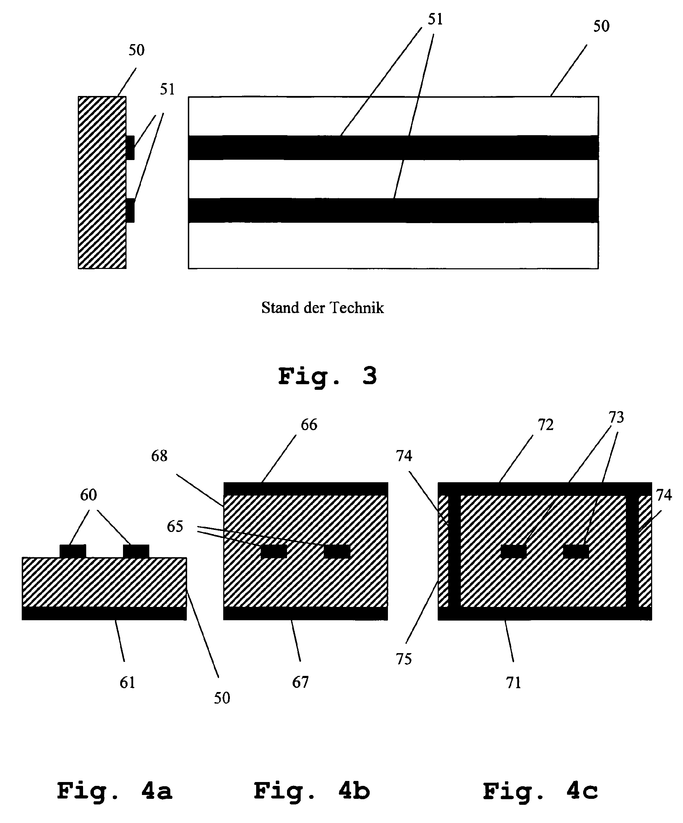

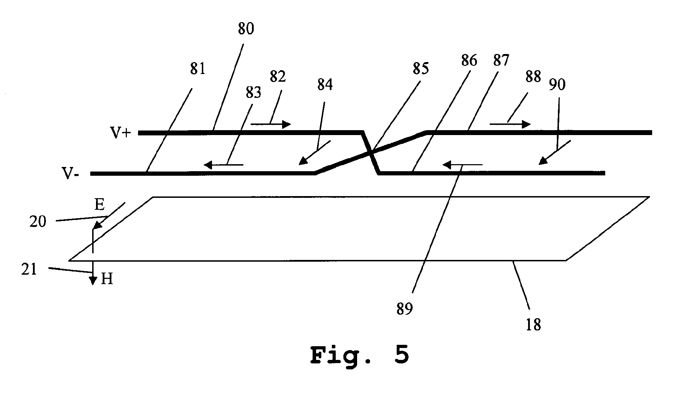

Zunächst wird anhand der Fig. 1 - 4 der Aufbau und die Funktionsweise von dem Stand der Technik angehörigen Leitungen erläutert. Mittels Fig. 5 - 14 wird der Aufbau und die Funktionsweise verschiedener Formen der erfindungsgemäßen Einrichtung gezeigt. Identische Elemente wurden in ähnlichen Abbildungen zum Teil nicht wiederholt dargestellt und beschrieben. Die Skalierung der Achsen der Fig. 3, 4, 6, 7 und 9 ist nicht identisch. Die Dicke der Substrate und Streifenleitungen ist der besseren Übersichtlichkeit halber vergrößert dargestellt.

Fig. 1 zeigt eine beispielhafte Gleichtakt-Störung an einer Gegentakt-Übertragung über zwei Leitungen mit Massefläche. Die Leitungen 14 und 15 verlaufen über einer Massefläche 18. Die Leitung 14 ist mit positiver Spannung V+, die Leitung 15 mit negativer Spannung V- belegt. Ein störendes Magnetfeld 10 und ein störendes elektrisches Feld 11 liegen an. Es werden die Störspannungen 16, 17 und die Störströme 12, 13 erzeugt. Diese wirken beide gleichartig auf beide Leitungen 14, 15 und können daher von einer nachfolgenden Empfängerstufe eliminiert werden.

In Fig. 2 wird eine beispielhafte Gegentakt-Störung an einer Gegentakt-Übertragung über zwei Leitungen mit Massefläche gezeigt. Die Leitungen 14 und 15 verlaufen über einer Massefläche 18. Die Leitung 14 ist mit positiver Spannung V+, die Leitung 15 mit negativer Spannung V- belegt. Ein störendes Magnetfeld 21 und ein störendes elektrisches Feld 20 liegen an. Es wird die Störspannung 24 und die Störströme 22, 23 erzeugt. Diese Störgrößen wirken gegensätzlich auf beide Leitungen, und können daher von einer nachfolgenden Empfangsstufe nicht eliminiert werden. Diese Richtung der Störfelder 20, 21 ist daher besonders kritisch.

In modernen Bus- oder Telekommunikationssystemen kommen immer häufiger differenzielle Übertragungen zum Einsatz. Ein großer Vorteil solcher Systeme ist die Störfestigkeit gegenüber externen Gleichtakt-Einkopplungen. Dadurch, dass am Ende der Leitung nur das Differenzsignal zweier Adern ausgewertet wird, werden Gleichtaktstörungen ausgefiltert, also solche Störungen, die beide Leiter gleichartig betreffen (Fig. 1). Treten jedoch Gegentaktstörungen auf, die direkt ein differenzielles Signal erzeugen, bleiben diese auch nach der Auswertung des Differenzsignals erhalten (Fig. 2). Durch die zunehmende Verbreitung von differenziellen Signalquellen werden auch differenzielle Messgeräte und im Besonderen differenzielle Tastköpfe immer wichtiger. Auch bei differenziellen Tastköpfen werden differenzielle Leitungen verwendet, und auch bei diesen können Störeinkopplungen das Messergebnis verfälschen. Man benötigt also differenzielle Leitungen, die sich gegen alle Arten von Störeinkopplungen robust verhalten.

Schutz vor Störungen durch Einkopplung wird bei aktuellen Systemen häufig durch die Verwendung von Schirmmethoden erreicht. Diese Technik ist von massebezogenen Systemen bekannt und basiert darauf, dass eine Schirmmasse den Feldraum des Wellenleiters möglichst vollständig umschließt, so dass externe Felder nicht eindringen können. Der einfachste Ansatz ist, für eine differenzielle Übertragung zwei separate koaxiale Wellenleiter zu verwenden. Diese Lösung hat jedoch erhebliche Nachteile. In erster Linie ist sie ein hybrider Ansatz und nicht in gängiger Leiterplattentechnologie auszuführen. Es können also keine Bauelemente bestückt werden. Der Übergang auf planare Technologie erfolgt über Stecker, die mehr oder minder große Störstellen darstellen. Störungen, die nach solch einem Stecker auftreten, werden von der Schirmung nicht mehr geschützt. Der Wellenwiderstand ist nicht frei wählbar, sondern beträgt meist 100 Ohm für den differenziellen und 25 Ohm für den Gleichtaktmodus. Längentoleranzen der beiden Einzelkabel führen zu Konversion und damit schlechter Gleichtaktunterdrückung. Die Anordnung samt Stecker verbraucht viel Platz, ist teuer und die Kabel samt Schirmgeflecht haben ein hohes Gewicht.

Eine exotische Lösung ist ein sog. Tri-Axialer Wellenleiter. Hier kann der Wellenwiderstand in gewissen Grenzen eingestellt werden, und auch Längentoleranzen treten nicht auf. Da es für dieses System aber kaum Steckverbindungen gibt, findet es wenig Verwendung.

Um in planarer Technologie bleiben zu können, sind also Streifenleitungen wie in Fig. 3 zu bevorzugen. Bei Streifenleitungen kann der Wellenwiderstand für beide Modi beliebig gewählt werden. Ferner spielen Längentoleranzen keine Rolle. Man kann den Wellenleiter direkt und ohne störende Übergänge bis zu dem das Signal erzeugenden Bauelement führen. Die Leitungen sind klein, kompakt und leicht. Solch eine Streifenleitung kann auch auf flexiblen Leiterplatten erzeugt werden und bietet somit maximale Freiheit bei der mechanischen Anordnung. Leider hat eine differenzielle Streifenleitung wie in Fig. 3 keinerlei Schutz gegen differenzielle Einkopplung. Fig. 3 zeigt ein erstes beispielhaftes Substrat 50 mit zwei Streifenleitungen 51.

Um eine Streifenleitung zu schirmen, können nun wie in Fig. 4a, 4b, 4c mehrere Masseflächen und Masse-Durchkontaktierungen angebracht werden. So werden in Fig. 4a, 4b, 4c verschiedene beispielhafte Möglichkeiten der Schirmung von Streifenleitungen gezeigt. In Fig. 4a sind auf dem Substrat 50 zwei Streifenleitungen 60 aufgebracht. Die Rückseite des Substrats weist zur Schirmung eine Metallisierung 61 auf. Zur Verbesserung der Schirmung sind in Fig. 4b die Streifenleitungen 65 von einem weiteren Substrat 68 oder einer weiteren Substratlage umschlossen. Die beiden Seiten des Substrats 68 weisen zur Schirmung eine Metallisierung 66, 67 auf. Zur weiteren Verbesserung der Schirmung sind in Fig. 4c die Streifenleitungen 73 von einem dritten Substrat 75 eingeschlossen. Die beiden Seiten des Substrats weisen eine Metallisierung 71, 72 zur Schirmung auf. Zusätzlich ist das Substrat 75 zur Schirmung mittels Durchkontaktierungen 74 durchbrochen. Durch die relativ dünnen Schichtdicken, die üblicherweise in flexiblen Technologien zu Einsatz kommen (z.B. 50 µm Kaptonfolie oder 10 µm Polyimid), erzeugen solche Schirmschichten sehr große kapazitive Beläge. Der Wellenwiderstand ist nicht mehr frei wählbar und im Allgemeinen nur noch sehr klein. Beispielsweise muss ein Einzelleiter über einer Massefläche auf 50 µm Kaptonfolie ($\varepsilon r = 3,3$) bereits dünner als 100 µm sein, um einen Wellenwiderstand von 50 Ohm zu erzeugen. Bei 10 µm Polyimid ($\varepsilon r = 3,4$) wäre die nötige Leiterbahnbreite kleiner als 20 µm, was mit konventioneller Technologie und deren Toleranzen nicht reproduzierbar zu fertigen ist. Zusätzliche Schirmflächen oben und an den Seiten reduzieren die Streifenbreite noch weiter. Diese Einschränkungen machen eine vollständige Schirmung eines Wellenleiters, besonders in flexibler Leiterplattentechnologie, nahezu unmöglich.

Fig. 5 zeigt eine beispielhafte Gegentakt-Signal-Übertragung über zwei gekreuzte Leitungen mit Massefläche. Gegentaktstörungen greifen somit in jede Leiterschleife mit unterschiedlichem Vorzeichen ein und löschen sich im Resultat aus, wie in Fig. 5 zu sehen ist. Die Leitungen 80 und 81 verlaufen über einer Massefläche 18. Die Leitung 80 ist mit positiver Spannung V+, die Leitung 81 mit negativer Spannung V- belegt. Ein störendes Magnetfeld 21 und ein störendes elektrisches Feld 20 liegen an. Die Leitungen überkreuzen sich an dem Kreuzungspunkt 85. Nach der Überkreuzung werden die Leitungen 80 und 81 als Leitungen 86 und 87 bezeichnet. In den Leitungen 80 und 81 werden die Störspannung 84 und die Störströme 82 und 83 erzeugt. In den Leitungen 86 und 87 werden die Störspannung 90 und die Störströme 89 und 88 erzeugt. Die Störspannungen 84 und 90, wie auch die Störströme 82, 83, 88 und 89, heben sich bei homogenem Feldverlauf auf. Bei inhomogenem Feldverlauf verbleiben Reststörungen. Je größer die Anzahl der Überkreuzungen, desto geringer fallen die verbleibenden Störungen auf Grund von inhomogener Feldverteilung aus. Diese Leitungen sind robust gegen Störungen, und kommen trotzdem ohne die hohe Kapazität, große Bauform, den hohen Preis und das große Gewicht von koaxialen Leitungen aus.

Zur Vermeidung der vorgenannten Nachteile werden planare Leitungen mit Überkreuzungen vorgeschlagen. Dabei überkreuzen sich die beiden Leiter in regelmäßigen Abständen, der so genannten Periodizitätslänge 1.

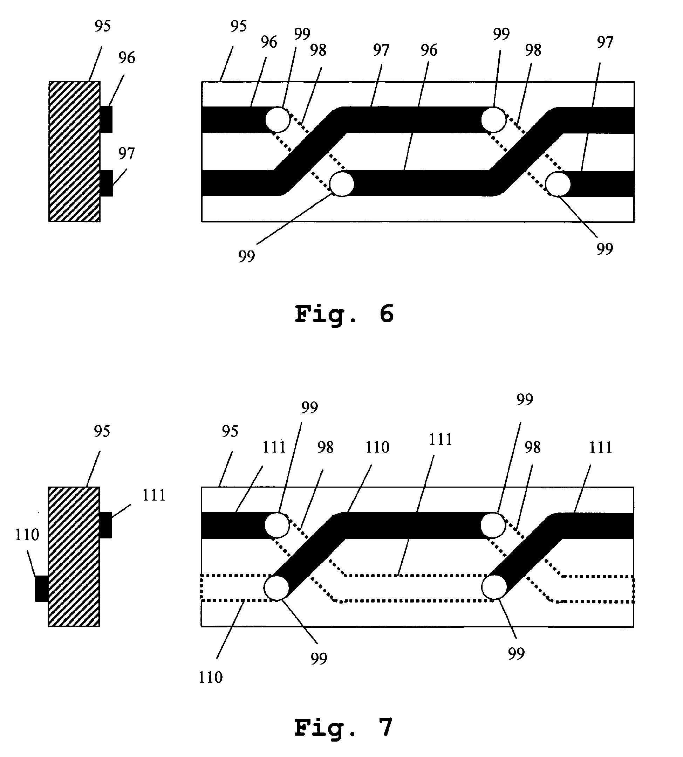

In Fig. 6 wird ein erstes Ausführungsbeispiel der erfindungsgemäßen Einrichtung gezeigt. Auf einer Seite eines Substrats 95 sind die Streifenleitungen 96 und 97 angebracht. Dabei verlaufen beide Streifenleitungen 96 und 97 im Wesentlichen auf der gleichen Seite des Substrats 95. Die Überkreuzungen werden durch Durchkontaktierungen 99 und Leiterstreifen 98 auf der Rückseite des Substrats 95 realisiert.

Fig. 7 zeigt ein zweites Ausführungsbeispiel der erfindungsgemäßen Einrichtung. Auf den beiden Seiten eines Substrats 95 sind die Streifenleitungen 110 und 111 angebracht. Dabei verlaufen die Streifenleitungen im Wesentlichen auf jeweils unterschiedlichen Seiten des Substrats 95, wobei sie bei jeder Überkreuzung ihre Position tauschen. Die Überkreuzungen werden durch Durchkontaktierungen 99 und Leiterstreifen 98 auf der Rückseite des Substrats 95 realisiert.

Eine solche Leitung ist komplett in planarer Technologie (mit Möglichkeit von Durchkontaktierungen) herzustellen.

Sie kann ohne Störstellen an signalerzeugende Bauelemente angeschlossen werden. Durch das Überkreuzen der Leitungen löschen sich Gegentaktstörungen aus. Der Wellenwiderstand ist nahezu beliebig frei einstellbar (s.u.). Unnötig große Kapazitäten durch eine Schirmmasse entfallen. Die Anordnung auf einer flexiblen Leiterplatte ist extrem leicht, Platz sparend und kann nahezu beliebig mechanisch verlegt werden. Es gibt keine Längentoleranzen der Einzelleiter und damit verbundene Modenkonversion.

Damit dieser Wellenleiter als (näherungsweise) homogener Wellenleiter betrachtet werden kann, ist es wichtig, dass die Periodizitätslänge 1 wesentlich kleiner als die Wellenlänge ist. Damit ergibt sich $1 < \lambda/10 \approx 1,5$ cm bei 1 GHz und $\varepsilon r = 3,3$.

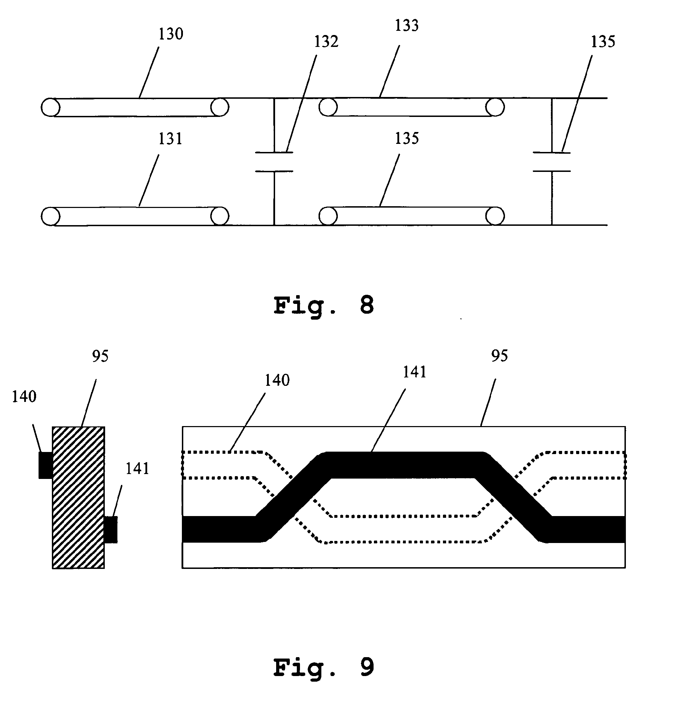

Der zugehörige Wellenwiderstand und die entsprechende effektive Dielektrizitätszahl ergeben sich aus dem Ersatzschaltbild aus Fig. 8. Die geraden Leitungselemente 130 und 133 bzw. 131 und 135 mit Wellenwiderstand Z0, einer effektiven Dielektrizitätszahl von $\varepsilon_{eff0}$ und einer Länge von 1 sind jeweils in Serie zu einem Kettenleiter verbunden. Sie entsprechen den Teil-Leitungen zwischen den Überkreuzungen. Jede Überkreuzung ist im Ersatzschaltbild durch eine parallele konzentrierte Kapazität 132, 135 abgebildet.

Kondensatoren werden im Bereich der Überkreuzungen betrachtet. Für den Kettenleiter gilt:

$$k = 1 + \frac{Z_0 c}{l\sqrt{\varepsilon_{eff\,0}}} C$$

$$Z = \sqrt{\frac{L'_{eff}}{C'_{eff}}} = Z_0 \sqrt{\frac{1}{k}}$$

$$\varepsilon_{eff} = k \cdot \varepsilon_{eff\,0}$$

Fig. 9 zeigt ein drittes Ausführungsbeispiel der erfindungsgemäßen Einrichtung. Auf den beiden Seiten eines Substrats 95 sind die Streifenleitungen 140 und 141 angebracht. Dabei verlaufen die Streifenleitungen vollständig auf jeweils unterschiedlichen Seiten des Substrats 95. Die Überkreuzungen werden ohne Durchkontaktierungen auf der Rückseite des Substrats 95 realisiert. Die Streifenleitungen tauschen lediglich auf ihrer jeweiligen Seite des Substrats 95 die Position. Dieses Ausführungsbeispiel zeichnet sich durch eine besonders einfache Realisierbarkeit aus. Gleichzeitig wird jedoch ein geringer Teil der einkoppelnden Störungen nicht ausgeglichen. Störungen, welche beispielhaft durch elektrische Feldanteile senkrecht zu der Substratoberfläche erzeugt werden, können nicht ausgeglichen werden. Dieser Anteil ist auf Grund der geringen Dicke des Substrats aber sehr gering.

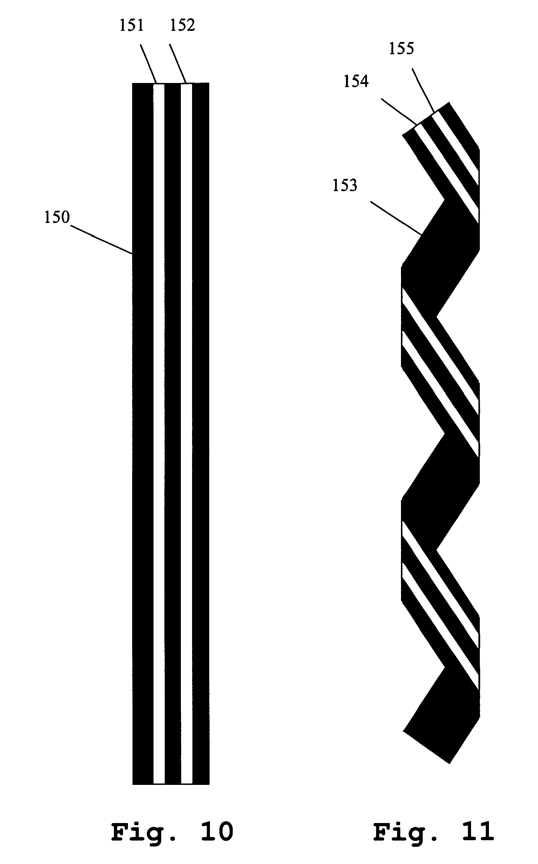

In Fig. 10 wird ein zweites beispielhaftes Substrat mit zwei Streifenleitern gezeigt. Auf einer Seite des Substrats 150 sind die beiden Streifenleiter 151 und 152 angebracht.

Fig. 11 zeigt ein viertes Ausführungsbeispiel der erfindungsgemäßen Einrichtung. Das hier gezeigte Ausführungsbeispiel wird durch Verdrillung des in Fig. 10 gezeigten Substrats 150 nach Aufbringung der Streifenleiter 151 und 152 erzeugt. Das Substrat 153 mit den daran befestigten Streifenleitern 154 und 155 ist verdrillt. So wird eine Überkreuzung der Streifenleiter mit sehr geringem fertigungstechnischem Aufwand erzielt. Die Verdrillung wird entweder durch eingespannte Montage oder durch Umspritzung des verdrillten Substrats 153 mit einem Abstandshalter erhalten.

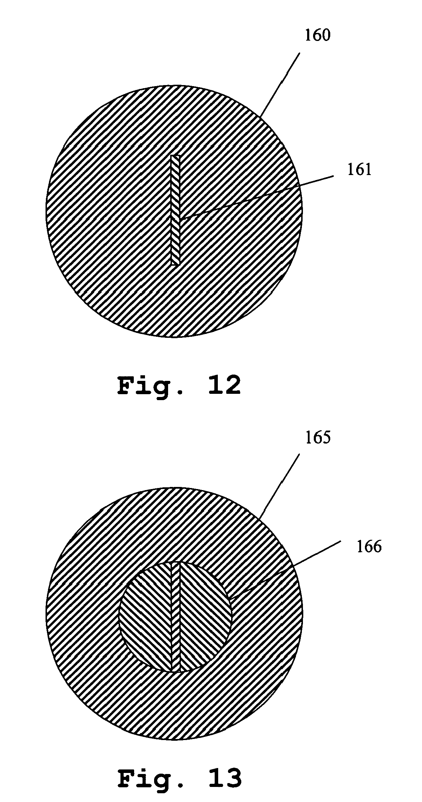

In Fig. 12 wird ein fünftes Ausführungsbeispiel der erfindungsgemäßen Einrichtung gezeigt. Das Substrat 161 mit überkreuzten Streifenleitungen wird von einer flexiblen Umspritzung 160 umgeben. So werden der Eintritt von Objekten in den Feldbereich verhindert und damit die Übertragungseigenschaften verbessert.

Fig. 13 zeigt ein sechstes Ausführungsbeispiel der erfindungsgemäßen Einrichtung. Das verdrillte Substrat 166 wird von einer flexiblen Umspritzung 165 umgeben. So werden der Eintritt von Objekten in den Feldbereich verhindert und damit die Übertragungseigenschaften verbessert. Eine Erhaltung der Verdrillung wird so sichergestellt.

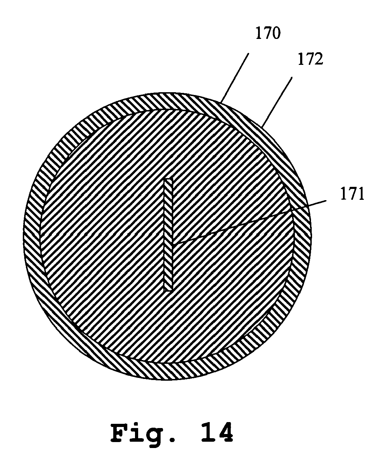

In Fig. 14 ist ein siebtes Ausführungsbeispiel der erfindungsgemäßen Einrichtung gezeigt. Das verdrillte Substrat 171 wird von einer flexiblen Umspritzung 172 umgeben. Zusätzlich ist es von einem rohrförmigen Mantelkörper 170 umgeben. So werden der Eintritt von Objekten in den Feldbereich mit großer Sicherheit verhindert und damit die Übertragungseigenschaften verbessert. Eine Erhaltung der Verdrillung wird so ebenfalls sichergestellt.

Die Erfindung ist nicht auf die dargestellten Ausführungsbeispiele beschränkt. Wie bereits erwähnt, können die überkreuzten Streifenleitungen zur Übermittlung unterschiedlicher Signale genutzt werden. Eine Beschränkung auf Zwei-Adern-Systeme und damit Gleichtakt- und Gegentakt-Signale besteht nicht. Als Substrat können ebenfalls unterschiedlichste Materialien eingesetzt werden. Alle vorstehend beschriebenen Merkmale oder in den Figuren gezeigten Merkmale sind im Rahmen der Erfindung beliebig miteinander kombinierbar.

**Patentansprüche**

**1.** Einrichtung zur Übertragung von elektrischen Signalen mit einem Substrat (95, 153, 161, 166) und zumindest zwei Streifenleitungen (96, 97, 110, 111, 140, 141, 154, 155), wobei die zumindest zwei Streifenleitungen (96, 97, 110, 111, 140, 141, 154, 155) an oder in dem Substrat (95, 153, 161, 166) angebracht sind,
**dadurch gekennzeichnet,**
**dass** die zumindest zwei Streifenleitungen (96, 97, 110, 111, 140, 141, 154, 155) mehrere Überkreuzungen aufweisen, und dass die mehreren Überkreuzungen in festgelegten Abständen über die Länge der Streifenleitungen (96, 97, 110, 111, 140, 141, 154, 155) verteilt angeordnet sind.

**2.** Einrichtung nach Anspruch 1,
**dadurch gekennzeichnet,**
**dass** die zumindest zwei Streifenleitungen (110, 111, 140, 141) zumindest abschnittweise auf unterschiedlichen Seiten oder in unterschiedlichen Lagen des Substrats (95, 161) angebracht sind.

**3.** Einrichtung nach Anspruch 1 oder 2,
**dadurch gekennzeichnet,**
**dass** die Überkreuzungen der Streifenleitungen (96, 97, 110, 111) mittels Durchkontaktierungen (99) durch das Substrat (95, 161) ausgeführt sind.

**4.** Einrichtung nach Anspruch 1 oder 2,
**dadurch gekennzeichnet,**
**dass** die Überkreuzungen der Streifenleitungen (140, 141, 154, 155) ohne Durchkontaktierungen durch das Substrat (95, 153) ausgeführt sind.

**5.** Einrichtung nach einem der Ansprüche 1 bis 4,
**dadurch gekennzeichnet,**
**dass** das Substrat (95, 153, 161, 166) eine dielektrische Leiterplatte ist.

**6.** Einrichtung nach einem der Ansprüche 1 bis 4,
**dadurch gekennzeichnet,**
**dass** das Substrat (95, 153, 161, 166) flexibel ist.

**7.** Einrichtung nach einem der Ansprüche 1 bis 4 und 6,
**dadurch gekennzeichnet,**
**dass** das Substrat (95, 153, 161, 166) ein Kunststofffilm ist.

**8.** Einrichtung nach Anspruch 6 oder 7,
**dadurch gekennzeichnet,**
**dass** das Substrat (153, 166) verdrillt ist.

**9.** Einrichtung nach einem der Ansprüche 6 bis 8,
**dadurch gekennzeichnet,**
**dass** das Substrat (161, 166) von einer flexiblen Ummantelung (160, 165), insbesondere Umspritzung, umgeben ist.

**10.** Einrichtung nach Anspruch 9,
**dadurch gekennzeichnet,**
**dass** das Substrat in einem flexiblen Mantelkörper eingespritzt ist.

**11.** Einrichtung nach Anspruch 9 oder 10,
**dadurch gekennzeichnet,**
**dass** die flexible Ummantelung (160, 165), insbesondere Umspritzung zumindest einen Durchmesser aufweist, welcher dem Doppelten des größten Abstands der zumindest zwei Streifenleitungen (96, 97, 110, 111, 140, 141, 154, 155) entspricht.

**12.** Einrichtung nach einem der Ansprüche 1 bis 11,
**dadurch gekennzeichnet,**
**dass** die zumindest zwei Streifenleitungen (96, 97, 110, 111, 140, 141, 154, 155) zur Übermittlung von Gegentakt-Signalen ausgelegt sind.

Fig. 1

Fig. 2

Stand der Technik

**Fig. 3**

**Fig. 4a       Fig. 4b       Fig. 4c**

**Fig. 5**

Fig. 6

Fig. 7

**Fig. 8**

**Fig. 9**

151   152

150

**Fig. 10**

155

154

153

**Fig. 11**

160

161

**Fig. 12**

165

166

**Fig. 13**

Fig. 14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6822463 B1